Europäisches Patentamt

European Patent Office

Office européen des brevets

(11) Publication number: **0 222 795**
**B1**

(12) **EUROPEAN PATENT SPECIFICATION**

(45) Date of publication of patent specification: **26.09.90**

(21) Application number: **86902744.1**

(22) Date of filing: **16.04.86**

(86) International application number:
**PCT/US86/00816**

(87) International publication number:
**WO 86/06877 20.11.86 Gazette 86/25**

(51) Int. Cl.⁵: **H 01 L 23/52, H 01 L 23/48, H 01 L 21/90**

(54) **POLYCIDE PROCESS IN SEMICONDUCTOR FABRICATION.**

(30) Priority: **03.05.85 US 730372**

(43) Date of publication of application:
**27.05.87 Bulletin 87/22**

(45) Publication of the grant of the patent:
**26.09.90 Bulletin 90/39**

(84) Designated Contracting States:
**BE DE FR GB IT NL SE**

(56) References cited:
**EP-A-0 054 129**
**WO-A-84/03391**
**FR-A-2 445 625**
**US-A-4 309 224**
**US-A-4 411 734**

**IEEE Journal of Solid State Circuits, volume SC-17, no. 2, April 1982, New York (US) Wang et al.: "Composite TiSi2/n+ Poly-Si low resistivity gate electrode and interconnect for VLSI device technology", page 177**

(73) Proprietor: **AMERICAN TELEPHONE AND TELEGRAPH COMPANY**
**550 Madison Avenue**
**New York, NY 10022 (US)**

(72) Inventor: **MANOCHA, Ajit, Singh**
**1363 North 21st Street**
**Allentown, PA 18104 (US)**
Inventor: **MAURY, Alvaro**
**5906 Club House Lane**
**Wescosville, PA 18106 (US)**
Inventor: **SINHA, Ashok, Kumar**
**2281 Bishop Road**
**Allentown, PA 18103 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

Courier Press, Leamington Spa, England.

**Description**

Background of the invention

State of the art VLSI devices have reached the point at which polysilicon conductors do not have sufficient conductivity to serve as interconnections in the complex and densely packed circuits now being designed. Consequently, refractory metal interconnects are now the design choice. A variety of refractory materials have been proposed, but the so-called bilayer poly-silicide (polysilicon plus a refractory metal silicide) conductors have been widely adopted.

Among the poly-silicide choices, one that has achieved wide acceptance is tantalum silicide-polysilicon. However, the tantalum silicide-polysilicon bilayer structure is known to be susceptible to instability of the interface. Under some conditions, which are not well defined, the tantalum silicide surface layer lifts or blisters. Reasons for this behavior are also not well known. Obviously, a solution to this problem is technologically important.

From observations and experiments made by us, we have developed an understanding of the poly-silicide lifting phenomenon, and an effective solution. We have observed that the problem is less frequent with p-type poly than with n-type. We have also conducted experiments that indicate that heavily doped n-type poly (15—20 ohm/sq. per 0.35 μm (3500 Å) thick or $0.525 \times 10^{-3}$ to $0.7 \times 10^{-3}$ Ωcm) exhibits the problem frequently, but undoped poly does not. "Heavily doped" poly means polysilicon saturated with phosphorus. Often this is done during diffusion in order to achieve highly uniform sheet resistance throughout the wafers. Based on this work, we attribute the lifting and blistering to impurities, i.e. phosphorus and arsenic, that evaporate from the polysilicon after deposition of the tantalum overlayer. The solution that appears indicated from our work, i.e. to use undoped polysilicon, is unacceptable for at least two reasons. If the polysilicon is used as connectors to n-regions it should be n-type. Moreover, the polysilicon should be doped to provide requisite conductivity in the event of discontinuities or defects in the conductive overlayer. Accordingly, conventional polysilicon, doped or undoped, is not adequate.

Statement of the invention

Based on the observations and recognitions outlined above, we have demonstrated a poly-silicide layer in which the polysilicon is sufficiently conductive, with the requisite n-type doping, but does not produce the interface instabilities described in the foregoing background of the invention. Our invention therefore, is a poly-silicide metallization layer in which the polysilicon component has a critical doping level of 25—50 ohm/square for 0.35 μm (3500 Å) thickness, 0.875—1.75 ohm cm. While this material may be defined broadly as n-type polysilicon, it is unconventional since the doping level is significantly different from doped polysilicon described and used in structures previously known (15—20 ohm/square). =EP—A—0,054,129 provides a poly-silicide layer, the polysilicon base layer of which is as highly doped as possible, such that the resistivity is less than 50 ohm/square. This document does not relate to the present problem.

Brief description of the drawing

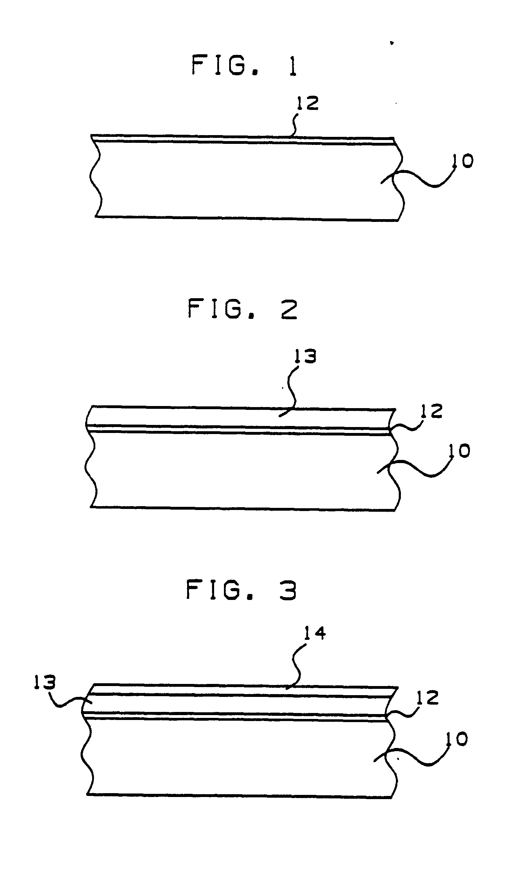

Figures 1—7 are schematic representations of a typical process sequence according to the invention.

Detailed description

In Figure 1 a substrate 10, typically silicon, is shown with gate dielectric 12. The conventional gate dielectric material is silicon dioxide although other materials, e.g. silicon nitride, or a dual dielectric of silicon dioxide and silicon nitride may be used as well. A polysilicon conductor layer 13 is deposited on the gate dielectric as shown in Figure 2. This layer may be the so-called poly I layer or a subsequent polysilicon layer.

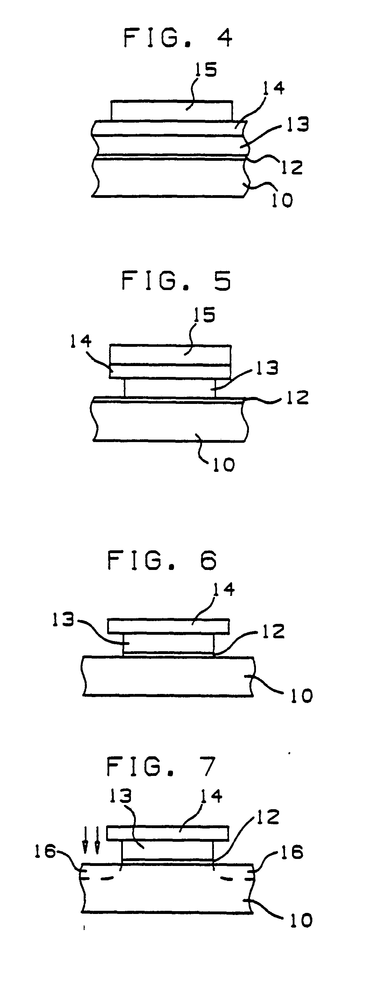

The polysilicon layer may be in situ doped or implanted to a resistivity in the range of approximately 1000—2000 μΩcm. Gate dielectric layer 12 is typically thin, of the order of 20 to 200 nm (200Å to 2000Å), most typically 20 nm (200Å) to 80 nm (800Å). Polyisilicon layer 13 may be of the order of a few thousand angstroms, e.g. 0.32 μm±30 nm (3200Å±300Å). A layer 14 of metal silicide, preferably titanium silicide or tantalum silicide, is deposited over the polysilicon layer as shown in Figure 3. The metal silicide layer, may also be of the order of a few thousand angstroms in thickness, e.g. 0.25 μm (2500Å). This composite structure is masked by conventional techniques, Figure 4, and then etched by reactive ion etching, Figure 5. The metal silicide layer is etched with, for example, Freon-11 for 5—6 minutes to remove layer 14 except for the portion masked by mask 15, and the polyisilicon layer 13 is etched, for example with a mixture of 15% $O_2$ and 85% $Cl_2$ for approximately 5 minutes to complete etching of the polysilicon layer. These layers can be dry etched using a variety of etching procedures known in the art. Those details form no part of the invention.

The mask 15 may then be removed (Figure 6) and the gate dielectric 12 etched to form windows for the introduction of impurities into the substrate. Typically these are for source-drain formation but may be for other purposes. If the poly-silicide layer is being processed at a subsequent stage in the processing sequence there may be no need for removal of an underlying layer. Alternatively, even when the region below and adjacent is to be implanted the implantation step can be made through the dielectric layer eliminating the need for its removal. Figure 7 shows the step of forming impurity regions 16 after removal of the gate dielectric 12.

At some point in the sequence of steps after deposition of the silicide material a sintering step is recommended. The mechanical and electrical properties of the poly-silicide appear to be improved and stabilized by heating the layer to a temperature of at least 900°C for a period of approximately 30 minutes. It will be understood by those skilled in the art that poly-silicide metallization has a variety of applications in integrated circuit technology. The choice of illustrating the polysilicide process for the formation of MOS gate structures is not meant to suggest that other applications are not equally important or advantageous. Use of poly-silicides for second level metal, or in three level processes, or simply for forming contacts between levels are all regarded as within the scope of the invention. It would appear to be equally useful in these applications to form the dual or composite structure in a manner that reduces or eliminates interface instabilities.

To establish that the presence of large amounts of dopants in the polysilicon layer prior to silicide deposition causes defective poly-silicide composite films the following detailed comparative study was made.

Experimental substrates were polished <100> p-type Si wafers, 7.5 cm in diameter, and 508 μm thick.

A group of wafers numbered 1 to 24, received first a dry oxidation to grow 36 nm (360Å) of gate oxide. Polysilicon was then deposited on all the wafers, using a LPCVD process. The films had a thickness of 380—400 nm (3.8—4 kÅ). Following the poly-Si deposition, the wafers numbered 1 to 12 received the phosphorus diffusion from a PBr$_3$ source that is used in the 2.5 μm process. The diffusion is done at 950°C for 30 minutes. The sheet resistance of the n$^+$ poly-Si films was 18—19 Ω/square. TaSi$_2$ was then deposited to a thickness of 0.25 μm (2500Å), on all the wafers. The silicide was cosputtered from two boron doped-Si and one Ta targets, in a DC magnetron (S-gun) sputtering system, with an argon pressure of 0.533 Pa (4×10$^{-3}$ torr). The silicide was sintered in an argon ambient at 900°C for 30 minutes. Wafers 1—6 and 19—24 were then selected to receive the poly-oxidation step, which is done at 900°C for 80 minutes in dry oxygen. This operation grew an oxide film on top of the TaSi$_2$, with a thickness ≈45 nm (≈450Å), as measured by using ellipsometry. The thickness measured agrees with values reported elsewhere.

Four different groups of six wafers each were then obtained, that had the following structures:

I. TaSi$_2$/n$^+$ poly-Si/SiO$_2$/Si (group 1, wafers 1—6)
II. SiO$_2$/TaSi$_2$/n$^+$ poly-Si/SiO$_2$/Si (group 2, wafers 7—12)
III. TaSi$_2$/undoped poly-Si/SiO$_2$/Si (group 3, wafers 13—18)
IV. SiO$_2$/TaSi$_2$/undoped poly-Si/SiO$_2$/Si (group 4, wafers 19—24).

In each of the four groups, two wafers received a double phosphorus implant, two a phosphorus and boron implants and a two a double boron implant. All the phosphorus implants were done at 100 keV energy and 4×10$^{15}$ ions/cm$^2$ dose, and the boron implants at 30 keV energy and 1×10$^{15}$ ions/cm$^2$ dose. One out of every two wafers with identical structures and implants was annealed at 900°C for 30 minutes in argon, before the second of the two implants. Following the ion implants, 0.1 μm (1 kÅ) of undoped SiO$_2$ and 1.6 μm (16 kÅ) of P-glass were deposited by LPCVD process on all the wafers. The glass was flowed in nitrogen at 1000°C for 90 minutes, and the wafers were then optically examined for defects.

The biaxial stresses in the TaSi$_2$ films were determined after every processing step, by measuring the stress induced changes in the curvature of the substrate, using an optically levered laser beam apparatus. In this technique the wafer is translated across the path of an incident laser beam and the radius of curvature is deduced from a measurement of the displacement of the reflected beam. The radius of curvature (r$_s$) of the substrate is measured prior to the film deposition. Once the film is deposited, the radius of curvature of the substrate plus film (r$_{f+s}$) is determined, following a processing step such as an implant or heat treatment. The stresses σ in the TaSi$_2$ films can then be calculated from the equation,

$$\sigma = \frac{E^2}{6(1-v)}\frac{D^2}{r_f t}$$

where

$$\frac{1}{r_f} = \frac{1}{r_{f+s}} - \frac{1}{r_s},$$

D and t are the substrate and film thicknesses respectively, (t≪D), E and v are Young's modulus and Poisson's ratio for the Si substrate respectively, such that

$$\frac{E}{1-v} = 0.18 \text{ Pa } (1.8\times10^{10} \text{ dynes/cm}^2)$$

for <100> Si. The gate oxide and polysilicon layers are grown on the front and back of the wafer, their net effect thus cancelling in the stress calculations. The effects of postgate processing steps on the TaSi$_2$ films were also monitored by sheet resistance measurements, using a four point probe. Cross section transmission electron micrographs of the blisters were obtained, using a technique that has been described previously.

The following processing variables have been investigated in this work: (1) the phosphorus doping of the polysilicon, (2) oxidation of the $TaSi_2$/poly-Si films, and (3) annealing of the implant damage.

There was a striking difference in the results obtained with wafers in which the polysilicon had been phosphorus doped ($PBr_3$), and the ones with undoped polysilicon: none of the wafers from the latter group blistered, while some of the wafers with P-doped poly, presented varying degrees of blistering.

The fact that the implants induced the blisters was clearly indicated by a sharp demarcation between the blistered surface and an annular area along the edge of the wafer, which was covered by a retaining meal ring during implants, and did not blister. The most severe blistering occurred in wafers 8 and 12 that were not oxidized after silicide sinter, and received P+P and P+B implants respectively. Blisters could be seen on all the implanted surface of the wafers. Some of the blisters were as large as 500 μm in diameter, making them visible without a microscope. Many of them appeared ruptured leaving exposed the inside surface.

The wafers that were oxidized after silicide sinter and then received P+P or P+B implants also blistered, but with substantially less severity than the unoxidized ones. Blisters could be seen only in the upper half of the wafers, near the edges of the implanted area. The center and bottom of the wafers appeared smooth under the optical microscope. The blisters seen in this case did not grow to a very large size, the maximum diameter being $\approx$10 μm, and none of them appeared to have burst.

The surface of the $TaSi_2$ did not show defects in the wafers that received a double boron implant.

Three of the original 24 wafers, were unavailable for inspection after P-glass flow. However, the same processing steps have been conducted on other samples. In all the cases, an anneal performed between two implants, has prevented the formation of blisters after P-glass flow.

As mentioned above, the wafers in which the polysilicon was not doped with phosphorus, did not blister. However, a different type of defect could be seen in some of them. A careful optical inspection revealed groups of voids on the wafers that had received a double phosphorus implant. The voids seemed to be produced by peeling of the $TaSi_2$ film, and, similar to the blisters, they also appeared only in the implanted area of the wafers. They differed from the blisters in that an anneal after the first implant did not prevent their appearance, and they seemed to be more numerous in the wafers that had received the poly-oxidation step. Wafer 22, which had received a P+B implant, also had voids, but in less degree than the wafers with double phosphorus implant.

The $TaSi_2$ films as deposited have almost zero stress. When the silicide is sintered, the stress increases to $\sim$0.12 Pa ($\sim$1.2$\times$10$^{10}$ dynes/cm$^2$) tensile, with a further additional increase to 0.14—0.16 Pa (1.4—1.6$\times$10$^{10}$ dynes/cm$^2$) after oxidation, A 100 keV, 4$\times$10$^{15}$ P$^+$/cm$^2$ or 30 keV, 1$\times$10$^{15}$ B$^+$/cm$^2$ implant, reduces the stress by $\sim$50% in the films that had been oxidized and by $\sim$75% in the as sintered ones. The enhanced resistance to implant damage of the oxidized films can be explained by the reduction in the implant depth into the silicide because of the shielding produced by the oxide film.

The stress recuperates its pre-implant value when the films are annealed at 900°C for 30 minutes. After the implant damage has been annealed out, a second boron or phosphorus implant produces changes in the stress which are almost identical to the ones that occur in as sintered films.

The change in the stress produced by the implants depends weakly on the dose. A boron over phosphorus implant produces an additional reduction of at most $\sim$1$\times$10$^8$ Pa ($\sim$1$\times$10$^9$ dynes/cm$^2$), the final stress remaining tensile, with a minimum value of $\sim$1$\times$10$^8$ Pa ($\sim$1$\times$10$^9$ dynes/cm$^2$) in the case of unoxidized $TaSi_2$/n$^+$ poly-Si.

The sheet resistance of as deposited $TaSi_2$/n$^+$poly-Si was $\approx$8 Ω/square, while for $TaSi_2$/undoped poly-Si it was $\approx$15 Ω/square. After sinter, the sheet resistance decreased to 2.5 Ω/square for $TaSi_2$/n$^+$ poly-Si, and to 3.4 Ω/square for $TaSi_2$/undoped poly-Si. In the films that received the poly-oxidation step after sinter, the sheet resistance had a further decrease of $\sim$0.1 Ω/square for $TaSi_2$/n$^+$ poly-Si, and $\sim$0.7 Ω/square in $TaSi_2$/undoped poly-Si. A possible explanation for the higher decrease in the latter case, is the growth of larger grains in the silicide film during oxidation.

Unlike the stress, there was a noticeable difference on the effects of a phosphorus versus a boron implant, on the sheet resistance. When implanted with phosphorus, the sheet resistance of the films increase by a factor of 2. The increase was $\times$1.5 after the boron implant. This is compatible with a larger concentration of scattering centers in the silicide film after the higher dose phosphorus implant. However, a second phosphorus implant increases only slightly the sheet resistance.

Similar to the stress, the sheet resistance recuperates its pre-implant value, after an anneal. A second implant into the annealed films, produces a change in the sheet resistance which is almost identical to what occurs in films implanted for the first time.

The dome shape of the blisters observed is consistent with internal gas pressure as well as compressive stresses at local sites. A possible mechanism for the formation of the blister is by coalescence of small sized gas bubbles. The bubbles in turn, nucleate by the coalescence at high temperature of impurity-vacancy pairs produced by high energy implants. The experimental evidence for the existence of the bubbles in the $TaSi_2$/n$^+$ poly-Si are TEM micrographs of blisters. Similar phenomena have been reported in studies of radiation induced blistering in metals and alloys, and in the bubble formation at the interface of the metal/Si system implanted with argon. (see *Journal of Applied Physics*, "Inert-gas-bubble formation in the implanted metal/Si system", B.Y. Tsaur et al, Vol. 50, pp. 3978, 1979).

Our experimental evidence indicates that there is an implant damage-impurity concentration threshold, above which, blistering will occur in TaSi$_2$/n$^+$poly-Si. This is consistent with a model (see *Nature,* "Formation of blisters in molybdenum bombarded with helium", J. H. Evans, Vol. 256, p. 299, 1975) that was proposed to explain blistering in molybdenum implanted with helium: if the bubbles created by the implants have a very low mobility, their coalesce only becomes rapid when they are touching, that is, when their concentration reaches a critical value. A consequence of this model is that coalescence, once started becomes a runaway process, because the coalescence of two gas bubbles at constant volume increases the internal pressure. This can be seen by considering two equal equilibrium gas bubbles, of radius r, where the internal pressure p is given by p=2 γ/r, γ the surface energy. If the two bubbles coalesce and the new bubble is assumed to be spherical with a volume that is the sum of the volumes of the original ones, the new equilibrium gas pressure should be lower by a factor of $2^{1/3}$ but the amount of gas remains constant, giving to the bubble an internal pressure 26% above the equilibrium value. As coalescence proceeds, the internal pressure will increase rapidly until it is high enough to deform the top layer.

In the TaSi$_2$/n$^+$ poly-Si structure, the gas pressure (at high temperatures), could be provided by phosphorus from the PBr$_3$ doped polysilicon substrate, and by argon, which is always present in silicide films deposited by sputtering with an argon plasma.

Argon has been proposed previously as the cause of the blisters in TaSi$_2$/poly-Si. Preliminary results of a study which is being conducted, indicate that argon is indeed released when the blisters burst. It is possible that the argon provides most of the pressure in the blisters, but nucleation of the bubbles only occurs when there is a high concentration of dopants at the TaSi$_2$/poly-Si interface. This would explain why blisters do not occur if the polysilicon film is undoped.

The fact that an anneal between implants prevented the blisters from occurring, is probably due to loss of phosphorus and argon by evaporation during the heat treatment. It has previously been reported (see *Journal of Applied Physics,* "Phosphorus distribution in TaSi$_2$ films by diffusion from a polycrystalline silicon layer", J. Pelleg and S. P. Murarka, Vol. 54, March, 1983) that phosphorus is depleted by evaporation when the TaSi$_2$/n$^+$ poly-Si film is heated to 900°C, without a thick oxide cap. Also, we point out that in wafer 4, which except for etching of the poly-silicide, had the normal post-gate processing steps, blistering occurred after flow. Under normal conditions blistering does not occur in device wafers, and this is probably due to a higher depletion of gaseous species from the narrow poly-silicide runners, during sinter of the silicide.

It must also be emphasized that concerning the implant, the critical factors for the formation of blisters in TaSi$_2$/n$^+$poly Si are the energy and dose. Besides phosphorus, blisters can also occur with implants of arsenic or argon.

The origin of the "voids" observed in the TaSi$_2$ surface of the wafers with undoped polysilicon and double implanted with phosphorus, can probably be explained by a pile-up of phosphorus on the vicinity of the top oxide layer. This could possibly lead to loss of adherence and subsequent peel off of thin layer of the TaSi$_2$ film. Such a pile-up of phosphorus has been reported by Pelleg et al in their studies of phosphorus distribution in TaSi$_2$/n$^+$poly-Si. They also report a pile-up of phosphorus at the interface, which lends support to our model of blister formation.

With the realization that normal doping levels for polysilicon create these disadvantages we adjusted the doping levels to the range previously prescribed, i.e., 1000—2000 Ωcm. Hundred of wafers have been processed using this critical doping level without significant level dropout due to the defects formerly observed.

The use of this invention also provides an additional and very important, advantage. Recent investigations show that the contact resistance between aluminum and TaSi layers is strongly affected by phosphorus initially present in the polysilicon film. The phosphorus diffuses into the TaSi$_2$ during the annealing step performed to reduce the resistivity of the silicide, and reacts with the Ta to form TaP compounds which upon oxidation create insulating or highly resistive layers. If the phosphorus level of the polysilicon is kept in the range prescribed the problem of high contact resistance is minimized.

**Claims**

1. Method for forming poly-silicides comprising:
depositing a base layer of polysilicon,
forming a layer of titanium silicide or tantalum silicide over the base layer to form a composite layer of silicide and polysilicon, and heating the thus formed composite layer to a temperature of at least 850$^C$ to sinter, characterized by
doping said base layer of polysilicon during deposition thereof or after deposition thereof with n-type impurities to a resistivity level in the range 25 to 50 ohm/square.

2. The method of Claim 1 in which each layer has a thickness of a few hundred nanometers (a few thousand angstroms).

3. The method of Claim 1 in which the polysilicide is formed on a dielectric layer.

4. The method of Claim 1 in which the impurities are phosphorus.

5. The method of Claim 1 in which the impurities are arsenic.

6. The method of Claim 3 in which the dielectric layer is silicon dioxide.

7. The method of Claim 1 in which the polysilicide layer is patterned to form electrical interconnections in an integrated circuit.

**Patentansprüche**

1. Verfahren zum Erzeugen von Polysiliciden, umfassend
—Niederschlagen einer Polysilicium-Grundschicht,
—Erzeugen einer Titansilicid- oder Tantalsilicid-Schicht über der Grundschicht, um eine zusammengesetzt Schicht aus Silicid und Polysilicium zu erzeugen, und
Erwärmen der solcherart erzeugten zusammengesetzten Schicht auf eine Temperatur von wenigstens 850°C zur Sinterung gekennzeichnet durch
Dotieren der Polysiliciumschicht während oder nach deren Niederschlagens mit n-Typ-Fremdstoffen auf einen Wert des spezifischen Quadratflächenwiderstandes im Bereich von 25 bis 50 Ohm.

2. Verfahren nach Anspruch 1, bei dem
—jede Schicht ein Dicke von einigen Hundert Nanometer (einigen Tausend Angström) besitzt.

3. Verfahren nach Anspruch 1, bei dem
—das Polysilicid auf einer dielektrischen Schicht erzeugt wird.

4. Verfahren nach Anspruch 1, bei dem
—die Fremdstoffe Phosphor sind.

5. Verfahren nach Anspruch 1, bei dem
—die Fremdstoffe Arsen sind.

6. Verfahren nach Anspruch 3, bei dem
—die dielektrische Schicht Siliciumdioxid ist.

7. Verfahren nach Anspruch 1, bei dem
—die Polysilicidschicht gemustert wird, um elektrische Zwischenverbindungen in einer integrierten Schaltung zu erzeugen.

**Revendications**

1. Procédé de formation de structures polysilicium-siliciure comprenant:
le dépôt d'une couche de base de polysilicium
la formation d'une couche de siliciure de titane ou de siliciure de tantale sur la couche de base pour former une couche composite de siliciure et de polysilicium, et le chauffage de la couche composite ainsi formée jusqu'à une température d'au moins 850°C, pour l'agglomération; characterise par
le dopage de la couche de base de polysilicium pendant son dépôt, ou après son dépôt, avec des impuretés de type n, jusqu'à un niveau de résistivité dans la plage de 25 à 50 ohms/carré.

2. Le procédé de la revendication 1, dans lequel chaque couche a une épaisseur de quelques centaines de nanomètres (quelques milliers d'angströms).

3. Le procédé de la revendication 1, dans lequel la structure polysilicium-siliciure est formée sur une couche diélectrique.

4. Le procédé de la revendication 1, dans lequel les impuretés sont du phosphore.

5. Le procédé de la revendication 1, dans lequel les impuretés sont de l'arsenic.

6. Le procédé de la revendication 3, dans lequel la couche diélectrique est du dioxyde de silicium.

7. Le procédé de la revendication 1, dans lequel on forme un motif dans le couche de polysilicium-siliciure pour former des interconnexions électriques dans un circuit intégré.

FIG. 1

FIG. 2

FIG. 3

FIG. 4

FIG. 5

FIG. 6

FIG. 7